# EUROPÄISCHE PATENTANMELDUNG

(11) **EP 3 557 538 A1**
(43) Veröffentlichungstag der Anmeldung: **23.10.2019**
(21) Anmeldenummer: 19177965.1
(22) Anmeldetag: 23.12.2013
(51) Int. Cl.: G07C 9/00, H01H 9/02

(54) **GEHÄUSE, INSBESONDERE FÜR EINEN ELEKTRONISCHEN SCHLÜSSEL**

(30) Priorität: 29.12.2012 DE 102012025239; 29.12.2012 DE 102012025240; 29.12.2012 DE 102012025242; 29.12.2012 DE 102012025243; 29.12.2012 DE 102012025241
(62) Teilanmeldung aus: 13836205.8
(71) Anmelder: Marquardt GmbH, 78604 Rietheim-Weilheim (DE)
(72) Erfinder: Fitz, Hartmut, 73660 Urbach (DE); Dufner, Michael, 78606 Seitingen-Oberflacht (DE); Geber, Michael, 72574 Bad Urach (DE); Ruther, Markus, 73734 Esslingen (DE); Villing, Gerd, 78592 Egesheim (DE)
(74) Vertreter: Otten, Roth, Dobler & Partner mbB Patentanwälte

(57) **Zusammenfassung**

Die Erfindung betrifft ein Gehäuse (2), insbesondere für einen elektronischen Schlüssel (1) eines Schließsystems eines Kraftfahrzeugs, das wenigstens ein Gehäuseteil, und zwar insbesondere ein Gehäuseunterteil (4") und/oder ein Gehäuseoberteil (4'), umfasst. An dem einen Gehäuseteil (4') ist wenigstens ein Touchfeld als Bedienelement (3) mit einer Betätigungsfläche (6) zur manuellen Einwirkung mittels eines Elements befindlich. Bei dem Element handelt es sich insbesondere um den Finger einer menschlichen Hand. Die Betätigung des Bedienelements (3) dient zum Schalten und/oder Auslösen einer zugeordneten Funktion. Das eine Gehäuseteil (4') weist eine weitgehend geschlossene Oberfläche (5) auf. Die Betätigungsfläche (6) ist in der Oberfläche (5) des Gehäuseteils (4') befindlich, derart dass ein stetiger und/oder unterbrechungsloser und/oder fugenloser Übergang, insbesondere ein glatter Übergang, zwischen der Betätigungsfläche (6) und der Oberfläche (5) des Gehäuseteils (4') gegeben ist. Zur Vermeidung von Fehlbetätigungen ist das Bedienelement erst nach Freigabe einer Tastensperre vom Benutzer betätigbar, wobei die Tastensperre eine Wisch- und/oder Gestenfunktion für das Touchfeld (10) umfasst.

## Beschreibung

Die Erfindung betrifft ein Gehäuse nach dem Oberbegriff des Patentanspruchs 1.

Solche Gehäuse werden insbesondere für einen elektronischen Schlüssel, einen Identifikations(ID)-Geber o. dgl. eines Schließsystems in einem Kraftfahrzeug verwendet.

Schließsysteme für Kraftfahrzeuge sind zur Steigerung des Komforts für den Benutzer oft mit einem elektronischen Schlüssel ausgestattet. Nach entsprechender Betätigung durch den Benutzer wird zwischen dem Schlüssel und einem Steuergerät im Kraftfahrzeug ein Code, beispielsweise über ein Betriebssignal mittels elektromagnetischen Wellen, ausgetauscht, so dass nach positiver Auswertung des Codes die Türen, der Kofferraumdeckel o. dgl. des Kraftfahrzeugs fernbedienbar ent- und/oder verriegelt sowie sonstige Funktionen ausgelöst werden.

Solche Schließsysteme sind auch mit sogenannten "Keyless"-Funktionalitäten weiterentwickelt. So ist bei der "KeylessEntry"-Funktionalität eine manuelle Betätigung des elektronischen Schlüssels durch den Benutzer nicht mehr notwendig. Es genügt, dass der Benutzer den Schlüssel mit sich führt. Das Betriebssignal wird dann für die Zugangsberechtigung zwischen dem Schlüssel und dem Steuergerät im Kraftfahrzeug selbsttätig übertragen, wenn der Benutzer sich in einem, in der Nähe des Kraftfahrzeugs befindlichen Wirkbereich aufhält und dort beispielsweise den Türgriff an der Autotüre betätigt. Ebenso können diese Schließsysteme eine "KeylessGo"-Funktionalität aufweisen, wobei das Betriebssignal für die Fahrberechtigung zwischen dem Schlüssel und dem Steuergerät im Kraftfahrzeug selbsttätig übertragen wird, wenn der Benutzer sich innerhalb des Kraftfahrzeugs befindet und beispielsweise eine Start/Stop-Taste im Armaturenbrett betätigt.

Ein derartiger elektronischer Schlüssel ist aus der DE 199 15 969 A1 bekannt. Das Gehäuse des Schlüssels umfasst wenigstens ein Gehäuseteil. Dabei kann das Gehäuse aus einem Gehäuseunterteil sowie einem Gehäuseoberteil bestehen. An einem Gehäuseteil ist wenigstens ein Bedienelement zur Bedienung des Schlüssels durch den Benutzer befindlich. Das Bedienelement weist eine Betätigungsfläche zur manuellen Einwirkung mittels eines Elements auf, wobei es sich insbesondere bei dem Element um den Finger einer menschlichen Hand handelt. Die Betätigung des Bedienelements durch den Benutzer dient dann wiederum zum Schalten und/oder Auslösen der zugeordneten Funktion des Schließsystems, wie oben erwähnt ist.

Bei dem bekannten elektronischen Schlüssel besteht das Bedienelement aus einem elektrischen Tastschalter. Die Betätigungsfläche des elektrischen Schalters ist vom Finger des Benutzers bewegbar. An der Oberfläche des Gehäuses sind daher Querschnittsverringerungen an der Betätigungsfläche und/oder am Rand der Betätigungsfläche beziehungsweise sonstige Nuten, Spalte o. dgl. vorzusehen, damit die Bewegbarkeit der Betätigungsfläche gegeben ist. Es besteht die Gefahr, dass Risse und/oder sonstige Beschädigungen aufgrund der Bewegung der Betätigungsfläche an der Oberfläche des Gehäuses zumindest nach einer gewissen Gebrauchsdauer auftreten. An derartigen Beschädigungen können dann Schadstoffe am Bedienelement in das Gehäuseinnere eindringen, wodurch wiederum die Funktionsfähigkeit des elektronischen Schlüssels beeinträchtigt wird.

Der Erfindung liegt die Aufgabe zugrunde, das Gehäuse derart weiterzuentwickeln, dass ein Eindringen von Schadstoffen in das Gehäuseinnere am Bedienelement weitgehend verhindert ist. Insbesondere soll ein Gehäuse mit einem neuartigen Bedienelement für einen elektronischen Schlüssel geschaffen werden.

Diese Aufgabe wird bei einem gattungsgemäßen Gehäuse durch die kennzeichnenden Merkmale des Anspruchs 1 gelöst.

Beim erfindungsgemäßen Gehäuse weist das eine Gehäuseteil, das das Bedienelement enthält, eine weitgehend geschlossene Oberfläche auf. Die Betätigungsfläche ist dabei derart in der Oberfläche des Gehäuseteils befindlich, dass ein stetiger und/oder unterbrechungsloser und/oder fugenloser Übergang, und zwar insbesondere ein glatter Übergang, zwischen der Betätigungsfläche und der Oberfläche des Gehäuseteils gegeben ist. Geschaffen ist somit ein Fahrzeugschlüssel mit geschlossener Bedienoberfläche, wobei Querschnittsverringerungen zwischen der Betätigungsfläche und der Oberfläche des Gehäuses vermieden sind. Die Gefahr von Beschädigungen der Oberfläche, insbesondere nach einer gewissen Gebrauchsdauer, ist dadurch weitgehend vermieden, so dass vorteilhafterweise ein Eindringen von Schadstoffen am Bedienelement in das Gehäuse verhindert ist. Dadurch ist wiederum die Funktionssicherheit für den elektronischen Schlüssel gesteigert. Weitere Ausgestaltungen der Erfindung sind Gegenstand der Unteransprüche.

In funktionssicherer sowie auch einfacher und kostengünstiger Ausgestaltung kann ein Sensor mit der Betätigungsfläche derart zusammenwirken, dass der Sensor bei Annäherung des Elements an die Betätigungsfläche und/oder bei Berührung der Betätigungsfläche mittels des Elements und/oder bei Druckeinwirkung mittels des Elements auf die Betätigungsfläche ein Signal erzeugt. Das Signal kann dann in der Art eines Schaltsignals zum Schalten und/oder Auslösen der zugeordneten Funktion dienen.

In einfacher Weiterbildung kann die Oberfläche des einen Gehäuseteils eine geschlossene Folie und/oder ein transparentes Schutzfenster, insbesondere mit einem darunterliegenden Display, aufweisen. Mit Hilfe des Displays wird die Funktionalität des elektronischen Schlüssels weiter gesteigert.

Erfindungsgemäß weist das Bedienelement ein Touchfeld auf. Zweckmäßigerweise kann das Touchfeld in der Art eines Touchpads und/oder eines Touchscreens ausgestaltet sein. Dem Benutzer wird somit eine besonders gute sowie auch ergonomische Handhabbarkeit für den elektronischen Schlüssel geboten.

In funktionssicherer Art und Weise kann der Sensor mit kapazitiven Mitteln, resistiven Mitteln, optischen Mitteln o. dgl. arbeiten. Handelt es sich um einen optisch arbeitenden Sensor, so kann es sich anbieten, dass dieser mittels für das menschliche Auge unsichtbarer Infrarot(IR)-Strahlung arbeitet. Die genannten Arbeitsweisen bieten sich insbesondere auch zur Verwendung in dem Touchfeld für den elektronischen Schlüssel an.

Um Fehlbedienungen durch den Benutzer zu vermeiden, ist das Bedienelement lediglich nach Freigabe einer Tastensperre betätigbar . Durch die Verwendung eines Touchfelds dient in kostengüntiger Weise eine Wisch- und/oder Gestenfunktion durch den Benutzer für das Touchfeld zur Freigabe der Tastensperre .

Weiter kann eine visuelle und/oder haptische Rückmeldung der Betätigung des Bedienelements durch das Element für den Benutzer vorgesehen sein. Die Rückmeldung kann in ergonomischer Art und Weise mittels einer Vibration der Betätigungsfläche, einer entsprechenden Displayanzeige, eines Anzeige-Leuchtmittels o. dgl. erfolgen. Als Anzeige-Leuchtmittel kann beispielsweise eine Anzeige-LED dienen, die zur Rückmeldung aufleuchtet und/oder die Leuchtfarbe wechselt. Derartige Maßnahmen tragen ebenfalls zur Vermeidung von Fehlbedienungen bei.

Ein solchermaßen ausgestaltetes Gehäuse lässt sich in vorteilhafter Weise für einen elektronischen Schlüssel für ein Schließsystem eines Kraftfahrzeugs verwenden.

Für eine besonders bevorzugte Ausgestaltung des erfindungsgemäßen Gehäuses ist nachfolgendes festzustellen.

Es ist der Einsatz einer geschlossenen Oberfläche in Folientechnik und/oder als transparentes Schutzfenster mit darunterliegendem Display und/oder auch eine ähnliche Variante vorgesehen. Die Oberfläche kann rückseitig bedruckt sein und sollte hoch kratz- und/oder abriebfest sein. Die Realisierung der Schaltfunktion kann über das Touchfeld, und zwar kapazitiv, resistiv, mittels Infrarotstrahlung (IR), Gestenerkennung o. dgl. erfolgen. Ebenso kann das Bedienelement minimalen Hub, und zwar in etwa 0,1 bis 0,2 mm, mittels darunterliegenden Schnappscheiben und/oder ähnlichen Schaltmedien besitzen.

Zur Vermeidung von Fehlbetätigungen wird zuerst eine Tastensperre gelöst, die über eine spezielle Wisch- und/oder Gestenfunktion entsperrt wird . Eine Rückmeldung der Betätigung kann zusätzlich visuell und/oder haptisch erfolgen. Beispielsweise kann die Rückmeldung über eine Art Vibration, eine Displayanzeige und/oder eine Anzeige-LED erfolgen.

Die mit der Erfindung erzielten Vorteile bestehen insbesondere darin, dass durch Nutzung von gegebenenfalls in anderen Anwendungen an sich bekannten Technologien ein neues Bedienkonzept für einen Fahrzeugschlüssel realisiert ist. Desweiteren ist eine einfach und schnell bedienbare Tastensperre zum Schutz vor Fehlbetätigungen geschaffen. Der Einsatz des erfindungsgemäßen Gehäuses kann vielfältig für Schlüssel mit Funkfernbedienung und/oder auch im Keyless-Betrieb sowie für weitere Bedien- und/oder Fernbedienfunktionen erfolgen. Für die Oberfläche des Gehäuses ist eine weitgehende Designfreiheit gegeben. Insbesondere können Designnuten und/oder Designfugen an der Oberfläche frei positioniert werden, da diese technisch nicht notwendig sind, und müssen daher nicht am ansonsten technisch notwendigen Platz für das Bedienelement wie beim bisherigen Gehäuse liegen.

Ein Ausführungsbeispiel der Erfindung mit verschiedenen Weiterbildungen und Ausgestaltungen ist in den Zeichnungen dargestellt und wird im folgenden näher beschrieben. Es zeigen
- Fig. 1: einen elektronischen Schlüssel,
- Fig. 2: einen Schnitt in der Art einer Prinzipskizze entlang der Linie 2-2 in Fig. 1, wobei das Gehäuseunterteil weggelassen ist,
- Fig. 2a: ein Gehäuseteil des elektronischen Schlüssels in einer weiteren Ausführung,
- Fig. 3a: einen vergrößerten Ausschnitt aus Fig. 2a,

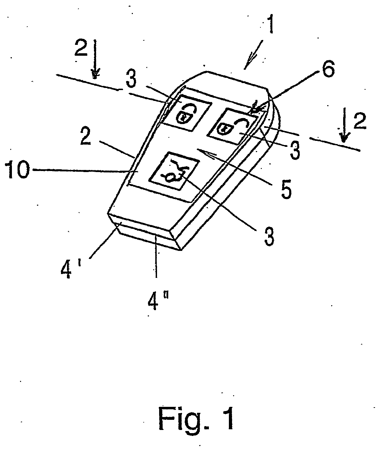

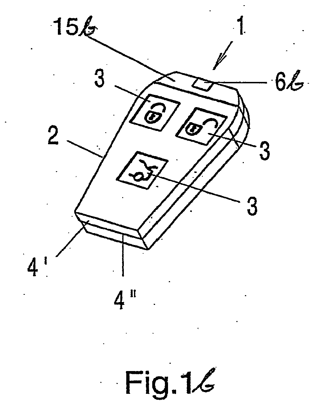

- Fig. 1b: einen elektronischen Schlüssel in einer noch weiteren Ausführung,

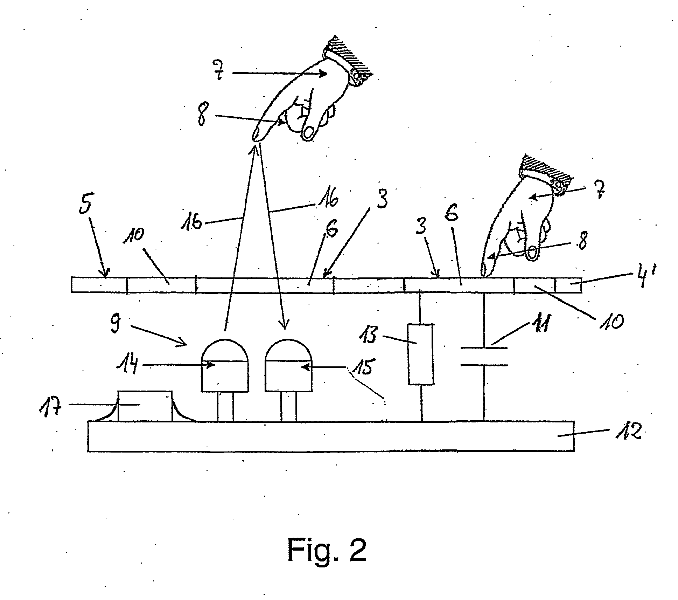

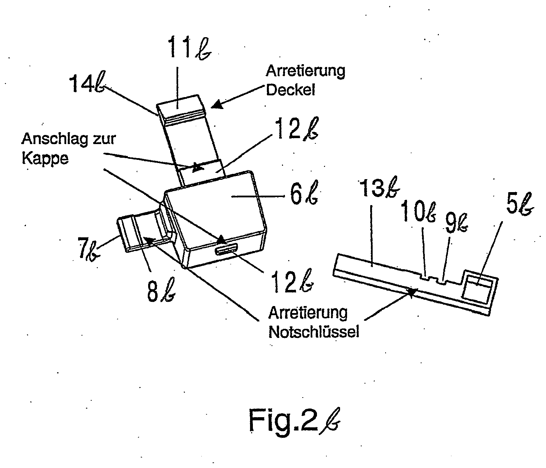

- Fig. 2b: den Drücker sowie Notschlüssel des Schlüssels gemäß Fig. 1b als Einzelteil,

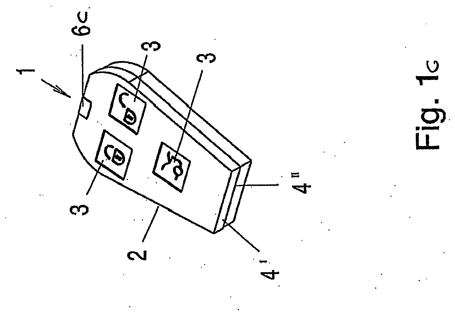

- Fig. 1c: einen elektronischen Schlüssel in nochmals einer weiteren Ausführung,

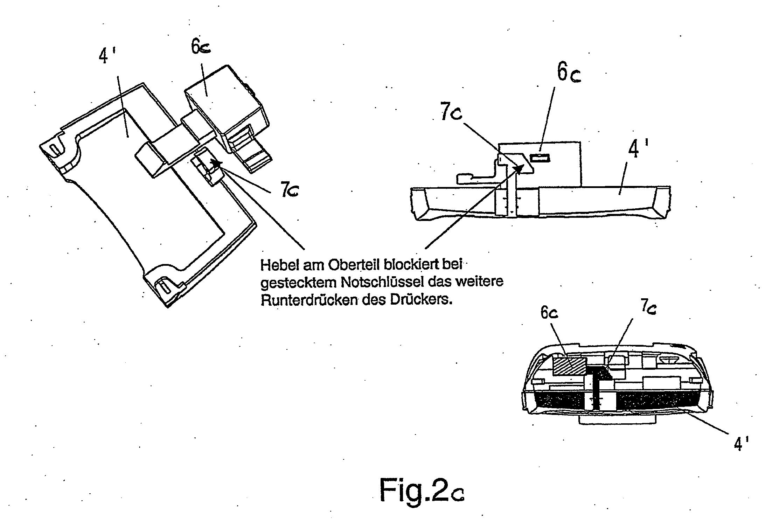

- Fig. 2c: das eine Gehäuseteil des elektronischen Schlüssels aus Fig. 1c gemäß einer ersten Ausgestaltung,

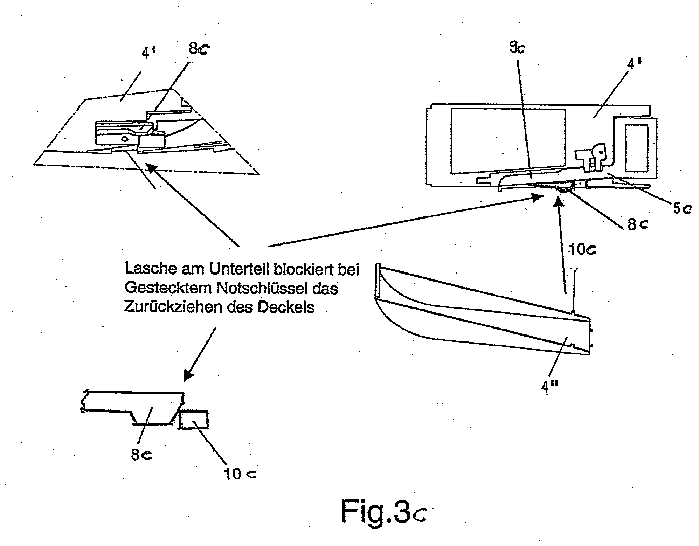

- Fig. 3c: das eine Gehäuseteil des elektronischen Schlüssels aus Fig. 1c gemäß einer zweiten Ausgestaltung,

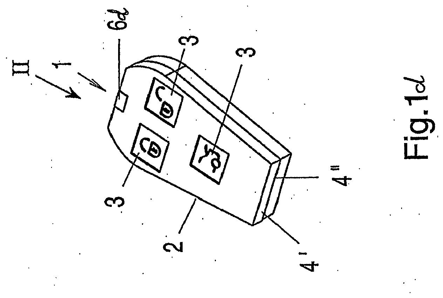

- Fig. 1: deinen elektronischen Schlüssel in einer nochmals weiteren Ausführung,

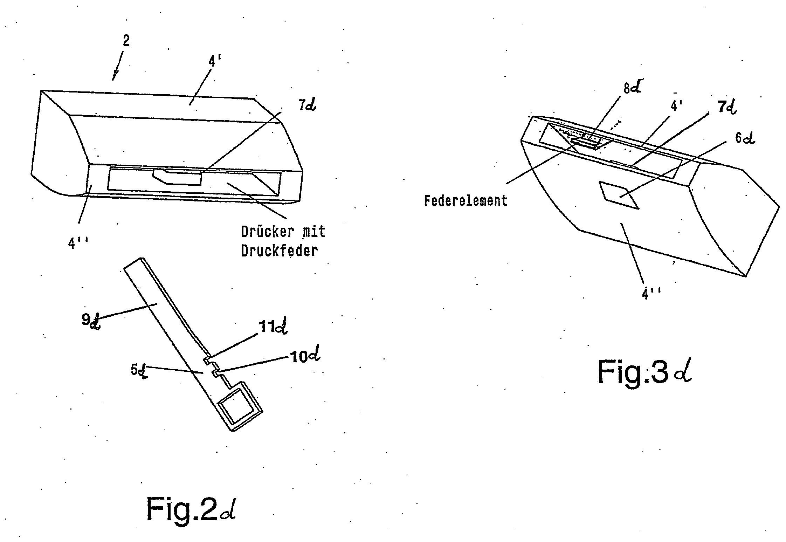

- Fig. 2d: einen Teil des Gehäuses des Schlüssels aus Richtung II in Fig. 1d gesehen sowie einen mechanischen Notschlüssel als Einzelteil und
- Fig. 3d: den Teil des Gehäuses aus Fig. 2d in einer weiteren Perspektive.

In Fig. 1 ist ein elektronischer Schlüssel 1 eines Schließsystems für ein Kraftfahrzeug zu sehen. Der Schlüssel 1 besitzt ein Gehäuse 2, an dem wenigstens ein Bedienelement 3 zur Auslösung von Funktionen am Kraftfahrzeug durch den Benutzer angeordnet ist. Vorliegend sind am Gehäuse 2 mehrere Bedienelemente 3 für die Auslösung verschiedener zugeordneter Funktionen vorgesehen. Beispielsweise lässt sich durch manuelle Betätigung der Bedienelemente 3 die Zentralverriegelung ver- und/oder entsperren sowie der Kofferraumdeckel öffnen, indem entsprechende codierte elektromagnetische Signale vom Schlüssel 1 zum Kraftfahrzeug gesendet werden. Weiterhin kann zusätzlich zur Zugangsberechtigung zum Kraftfahrzeug durch Austausch entsprechender codierter elektromagnetischer Signale zwischen dem Schlüssel 1 und dem Kraftfahrzeug die Authentifikation des Schlüssels 1 zur Fahrberechtigung für das Kraftfahrzeug erfolgen. Wie bereits erwähnt, kann der Schlüssel 1 auch mit einer Keyless-Funktionalität betreibbar sein.

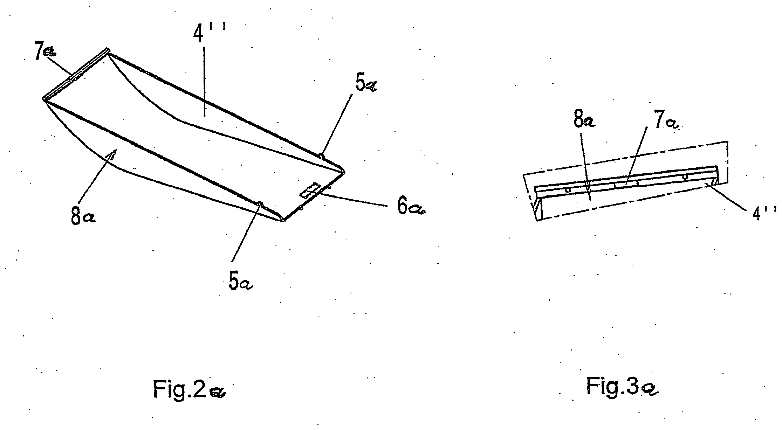

Das Gehäuse 2 umfasst wenigstens ein Gehäuseteil, und zwar vorliegend ein Gehäuseunterteil 4" sowie ein Gehäuseoberteil 4'. An dem einen Gehäuseteil 4', und zwar vorliegend am Gehäuseoberteil 4', befinden sich die Bedienelemente 3. Das Bedienelement 3 besitzt eine Betätigungsfläche 6 zur manuellen Einwirkung mittels eines in Fig. 2 gezeigten Elements 8. Wie näher in Fig. 2 dargestellt ist, kann es sich bei dem Element 8 um den Finger einer menschlichen Hand 7 handeln. Die Betätigung des Bedienelements 3 mittels des Fingers 8 an der Betätigungsfläche 6 dient dann zum Schalten und/oder Auslösen der jeweiligen, dem Bedienelement 3 zugeordneten Funktion des Schließsystems.

Das eine Gehäuseteil 4' weist gemäß Fig. 1 eine weitgehend geschlossene Oberfläche 5 auf. Die Betätigungsfläche 6 ist in der Oberfläche 5 des Gehäuseteils 4' befindlich, und zwar derart dass ein stetiger und/oder unterbrechungsloser und/oder fugenloser Übergang zwischen der Betätigungsfläche 6 und der Oberfläche 5 des Gehäuseteils 4' gegeben ist, wie man anhand der Fig. 2 erkennt. Insbesondere ist an der Oberfläche 5 des Gehäuseteils 4' ein glatter Übergang von der Betätigungsfläche 6 zu der umgebenden Oberfläche 5 gegeben.

Wie man weiter in Fig. 2 sieht, wirkt ein Sensor 9 mit der Betätigungsfläche 6 derart zusammen, dass der Sensor 9 bei Annäherung des Elements 8 an die Betätigungsfläche 6 und/oder bei Berührung der Betätigungsfläche 6 mittels des Elements 8 und/oder bei Druckeinwirkung mittels des Elements 8 auf die Betätigungsfläche 6 ein Signal erzeugt. Dieses Signal dient in der Art eines Schaltsignals zum Schalten und/oder Auslösen der dem jeweiligen Bedienelement 3 zugeordneten Funktion.

Zur Realisierung der weitgehend geschlossenen Oberfläche 5 kann die Oberfläche 5 des Gehäuseteils 4' eine geschlossene Folie und/oder ein transparentes Schutzfenster mit darunterliegendem Display 10 aufweisen. Die Bedienelemente 3 sind in einem Touchfeld 10, das beispielsweise in der Art eines Touchpads und/oder eines Touchscreens ausgestaltet ist, angeordnet. Ebenso kann das Bedienelement 3 einen elektrischen Tastschalter, der beispielsweise eine Schnappscheibe mit geringem Hub aufweist, umfassen.

In Fig. 2 sind diverse Realisierungen für den Sensor 9 dargestellt. So kann der Sensor 9 für das Touchfeld 10 kapazitiv, resistiv, optisch o. dgl. arbeiten. Bei einem kapazitiven Touchfeld 10 steht wenigstens ein Kondensator 11, der beispielsweise von elektrisch leitfähigen Flächen gebildet ist, mit der Betätigungsfläche 6 und einer im Gehäuse 2 befindlichen Leiterplatte 12 in elektrischer Verbindung. Bei einem resistiven Touchfeld 10 findet wenigstens ein ohm'sches Widerstandselement 13 Verwendung. Bei einem optisch arbeitenden Touchfeld 10 ist ein reflexionsoptischer Sensor 9 für die Detektierung des Elements 8 verwendet. Hierzu weist der Sensor 9 wenigstens einen optischen Sender 14, hier eine Leuchtdiode, und wenigstens einen optischen Empfänger 15, hier eine Fotodiode, für optische Strahlung 16 auf. Die Leuchtdiode 14 sowie die Fotodiode 15 sind auf der Leiterplatte 12 angeordnet. Die Leiterplatte 12 ist im Gehäuse 2 angeordnet, so dass der Sensor 9 im Inneren des Gehäuses 2 befindlich ist. Ebenfalls auf der Leiterplatte 12 befindet sich eine als Steuereinrichtung 17 dienende Elektronik zum Betrieb des Sensors 9 sowie zur Erzeugung des Signals. Die Steuereinrichtung 17 ist somit auch im Inneren des Gehäuses 2 befindlich. Bei der optischen Strahlung 16 handelt es sich bevorzugterweise um für das menschliche Auge unsichtbare Infrarot(IR)-Strahlung. Die Betätigungsfläche 6 ist für Infrarot-Strahlung im wesentlichen durchlässig, insbesondere indem ein IR-durchlässiger Kunststoff als Material für die Betätigungsfläche 6 beziehungsweise für das gesamte Gehäuseteil 4' gewählt ist.

Zweckmäßigerweise ist das Bedienelement 3 lediglich nach Freigabe einer Tastensperre vom Benutzer betätigbar. Zur Freigabe der Tastensperre wird eine Wisch- und/oder Gestenfunktion für das Touchfeld 10, die vom Finger 8 des Benutzers ausgeübt wird, verwendet. Schließlich ist noch eine visuelle und/oder haptische Rückmeldung der Betätigung des Bedienelements 3 für den Benutzer vorgesehen. Diese Rückmeldung kann mittels einer Vibration der Betätigungsfläche 6 erfolgen. Selbstverständlich kann hierfür auch eine entsprechende Displayanzeige, das Leuchten eines Anzeige-Leuchtmittels, beispielsweise einer Anzeige-LED, o. dgl. Verwendung finden,

Das Gehäuse 2 gemäß einer weiteren Ausführung umfasst wenigstens ein Gehäuseteil, und zwar vorliegend ein Gehäuseunterteil 4" sowie ein Gehäuseoberteil 4'. Das Gehäuseunterteil 4" ist als ein am Gehäuse 2 abnehmbarer und/oder aufsetzbarer Batteriedeckel ausgestaltet, um ein Wechseln der Batterie des Schlüssels 1 zu gestatten. Hierzu ist das eine Gehäuseteil 4" mittels wenigstens einer seitlichen Einhängenase 5a am anderen Gehäuseteil 4' geführt sowie mittels einer längs angeordneten Fixierrippe 6a am anderen Gehäuseteil 4' verrastet, wie anhand der Fig. 2a zu sehen ist. Dadurch ist ein Aufschieben des Gehäuseunterteils 4" am Gehäuseoberteil 4' zum Öffnen und/oder Schließen des Gehäuses 2 ermöglicht.

In dem einen Gehäuseteil 4" ist ein lichtdurchlässiges Element 7a, das als eine Funktionsanzeige und/oder als eine Funktionsbeleuchtung für den Schlüssel 1 dient, befindlich. Das lichtdurchlässige Element 7a besteht aus einem Lichtleiter. Wie man weiter anhand von Fig. 3a erkennt, ist der Lichtleiter 7a in dem einen Gehäuseteil 4" integriert, und zwar ist vorliegend das lichtdurchlässige Element 7a passend in die Kontur der Oberfläche des einen Gehäuseteils 4" integriert.

Zur Integration des Lichtleiters 7a in das Gehäuseteil 4" ist das eine Gehäuseteil 4" im 2K(Zwei-Komponenten)-Spritzgießverfahren hergestellt, wobei der Lichtleiter 7a aus einem transluszenten Kunststoff sowie das restliche Gehäuseteil 4" aus einem nicht-transluszenten Kunststoff besteht. Aufgrund dieser Ausgestaltung ist das lichtdurchlässige Element 7a bei Nichtbeleuchtung weitgehend unsichtbar in der Oberfläche des einen Gehäuseteils 4" befindlich. Bei Beleuchtung hingegen ist das lichtdurchlässige Element 7a sichtbar in der Oberfläche des einen Gehäuseteils 4" angeordnet.

Besonders geeignet für das Gehäuse 2 ist ein thermoplastischer Kunststoff. Bei dem transluszenten Kunststoff für den Lichtleiter 7a kann es sich um ein grau-transluszentes Polycarbonat handeln. Bei dem nicht-transluszenten Kunststoff kann es sich um ein schwarz eingefärbtes Copolymer aus Polycarbonat sowie Acrylnitril-Butadien-Styrol handeln. Zwecks Steigerung der Anmutung für das Gehäuse 2 besitzt wenigstens das eine Gehäuseteil 4" eine als Hochglanzoberfläche ausgebildete außenliegende Oberfläche 8a. Desweiteren ist die Oberfläche 8a des einen Gehäuseteils 4" mit einem UV-Klarlack lackiert.

Das Gehäuse 2 eines Schlüssels gemäß einer in Fig. 1b gezeigten Ausführung umfasst ein Gehäuseunterteil 4" sowie ein Gehäuseoberteil 4'. Das eine Gehäuseteil 4", also das Gehäuseunterteil 4", ist abnehmbar ausgestaltet und dient als Batteriedeckel, um ein Wechseln der Batterie des Schlüssels 1 zu gestatten. Desweiteren ist in das Gehäuse 2 ein in Fig. 2b gezeigter mechanischer Notschlüssel 5b mit einem Schlüsselbart 13b einsteckbar, wobei der mechanische Notschlüssel 5b zur Betätigung eines mechanischen Schlosses für den Notfall dient. Das abnehmbare Gehäuseteil 4" und/oder der Notschlüssel 5b sind mittels eines bewegbaren Drückers 6b verriegelbar am und/oder im Gehäuse 2 arretiert.

Der Drücker 6b gibt in einer ersten gedrückten Stellung den Notschlüssel 5b frei. Weiterhin gibt der Drücker 6b in einer zweiten gedrückten Stellung das abnehmbare Gehäuseteil 4" frei. Wie man in Fig. 2b sieht ist am Drücker 6b ein seitliches Rastelement 7b angeordnet, und zwar ist das Rastelement 7b quer in Bezug auf die Bewegungsrichtung des Drückers 6b angeordnet. Dadurch kann das Rastelement 7b zur Arretierung mit wenigstens einer Aussparung 9b am Notschlüssel 5b zusammenwirken. Vorliegend besitzt der Notschlüssel 5b zwei Aussparungen 9b, 10b, so dass der Notschlüssel 5b zwei unterschiedliche Rastpositionen im Gehäuse 2 aufweist. Dadurch kann der Notschlüssel 5b beispielsweise vollständig im Gehäuse 2 versenkt als auch teilweise aus dem Gehäuse 2 herausragend im Gehäuse 2 fixiert sein. Das Rastelement 7b weist eine Schräge 8b auf, so dass der Notschlüssel 5b ohne Betätigung des Drückers 6b durch den Benutzer in das Gehäuse 2 einführbar ist.

Desweiteren ist ein Rasthaken 11b zur Arretierung des abnehmbaren Gehäuseteils 4" oben am Drücker 6b befindlich, und zwar ist der Rasthaken 11b in Bewegungsrichtung des Drückers 6b angeordnet. Der Rasthaken 11b weist ebenfalls eine Schräge 14b auf, so dass das Gehäuseteil 4" ohne Betätigung des Drückers 6b durch den Benutzer am Gehäuse 2 aufsetzbar ist. Und zwar ist das Gehäuseteil 4" dadurch zur Montage in einfacher Art und Weise aufschnappbar.

Wie man weiter in Fig. 1b sieht ist der Drücker 6b in etwa mittig am Gehäuse 2 angeordnet, und zwar an einer Stirnseite des Gehäuses 2. An der Stirnseite des Gehäuses 2 ist weiterhin eine Kappe 15b befindlich, wobei die Kappe 15b beispielsweise zur Abdeckung des eingesteckten Notschlüssels 5b dient. Schließlich weist der Drücker 6b noch einen in Fig. 2 sichtbaren Anschlag 12b für die am Gehäuse 2 des Schlüssels 1 angeordnete Kappe 15b auf.

Das Gehäuse 2 gemäß einer in Fig. 1c gezeigten Ausführung umfasst ein Gehäuseunterteil 4" sowie ein Gehäuseoberteil 4'. Das eine Gehäuseteil 4", und zwar das Gehäuseunterteil 4", ist abnehmbar ausgestaltet und dient als Batteriedeckel, um ein Wechseln der Batterie des Schlüssels 1 zu gestatten. Vorliegend ist das abnehmbare Gehäuseteil 4" durch Verschieben am Gehäuse 2 abnehmbar und/oder aufsetzbar. Desweiteren ist in das Gehäuse 2 ein in Fig. 3c gezeigter Notschlüssel 5c, der als ein mechanischer Schlüssel mit einem Schlüsselbart 9c ausgebildet ist, einsteckbar.

Das abnehmbare Gehäuseteil 4" und/oder der Notschlüssel 5c sind mittels eines bewegbaren Drückers 6c verriegelbar am und/oder im Gehäuse 2 arretiert. Der Drücker 6c gibt in einer ersten gedrückten Stellung den Notschlüssel 5c zum Herausnehmen frei. Weiterhin gibt der Drücker 6c in einer zweiten gedrückten Stellung das abnehmbare Gehäuseteil 4" zum Abnehmen frei. Das Gehäuse 2 ist derart ausgebildet, dass das abnehmbare Gehäuseteil 4" lediglich nach Herausnehmen bzw. Entfernen des Notschlüssels 5c aus dem Gehäuse 2 abnehmbar bzw. demontierbar ist.

Wie in Fig. 2c zu sehen ist, ist ein Anschlag 7c, der insbesondere gefedert ausgestaltet ist, als Wegbegrenzung für den Drücker 6c vorgesehen. Der in der Art eines Hebels ausgestaltete Anschlag 7c blockiert bei eingestecktem Notschlüssel 5c das weitere Herunterdrücken des Drückers 6c, so dass die zweite Stellung des Drückers 6c bei eingesteckten Notschlüssel 5c blockiert ist. Der Anschlag 7c ist quer zur Bewegungsrichtung des Drückers 6c elastisch bewegbar ausgebildet, und zwar insbesondere in der Art eines gefederten Hebels. Dadurch ist der Anschlag 7c bei nicht im Gehäuse 2 befindlichen Notschlüssel 5c vom Drücker 6c aus der Bewegungsbahn des Drückers 6c auslenkbar. Bei im Gehäuse 2 befindlichen Notschlüssel 5c ist der Anschlag 7c vom Notschlüssel 5c in der Bewegungsbahn des Drückers 6c zur Blockierung der Bewegung des Drückers 6c festgehalten.

Wie in Fig. 3c zu sehen ist, ist ein weiterer Anschlag 8c, der insbesondere gefedert ausgestaltet ist, als Wegbegrenzung für das abnehmbare Gehäuseteil 4" vorgesehen. Der in der Art einer Lasche ausgestaltete Anschlag 8c blockiert bei eingestecktem Notschlüssel 5c das weitere Zurückziehen des abnehmbaren Gehäuseteils 4", so dass das Entfernen des abnehmbaren Gehäuseteils 4" bei eingesteckten Notschlüssel 5c blockiert ist.

Hierzu ist der am Gehäuseteil 4' befindliche Anschlag 8c quer zur Verschieberichtung des abnehmbaren Gehäuseteils 4" elastisch bewegbar ausgebildet, und zwar insbesondere in der Art einer gefederten Lasche. Ein Haken 10c am abnehmbaren Gehäuseteil 4" wirkt mit dem Anschlag 8c am Gehäuseteil 4' derart zusammen, dass der Anschlag 8c bei nicht im Gehäuse 2c befindlichem Notschlüssel 5c vom Haken 10c aus der Verschiebebahn des abnehmbaren Gehäuseteils 4" auslenkbar ist. Hingegen ist bei im Gehäuse 2 befindlichem Notschlüssel 5c der Anschlag 8c vom Notschlüssel 5c in der Verschiebebahn des abnehmbaren Gehäuseteils 4" festgehalten. Dadurch ist wiederum die Verschiebebewegung des abnehmbaren Gehäuseteils 4" aufgrund des Anliegens des Hakens 10c am Anschlag 8c blockiert.

Das Gehäuse 2 einer in Fig. 1d gezeigten weiteren Ausführung umfasst ein Gehäuseunterteil 4" sowie ein Gehäuseoberteil 4'. Das eine Gehäuseteil 4", also das Gehäuseunterteil 4", ist abnehmbar ausgestaltet und dient als Batteriedeckel, um ein Wechseln der Batterie des Schlüssels 1 zu gestatten. Desweiteren ist in das Gehäuse 2 ein in Fig. 2d gezeigter mechanischer Notschlüssel 5d mit einem Schlüsselbart 9d einsteckbar. Das abnehmbare Gehäuseteil 4" und der Notschlüssel 5d sind mittels eines eine Druckfeder aufweisenden, bewegbaren Drückers 6d verriegelbar am und/oder im Gehäuse 2 arretiert.

Wie man anhand von Fig. 2d sieht, weist der Drücker 6d ein Drückerteil 7d in der Art eines Rastelements zur Zusammenwirkung mit wenigstens einer Aussparung 10d am Notschlüssel 5d auf, womit der Notschlüssel 5d im Gehäuse 2 arretierbar ist. Der zur verriegelbaren Arretierung des Notschlüssels 5d am und/oder im Gehäuse 2 vorgesehene Drücker 6d gibt in einer ersten gedrückten Stellung den Notschlüssel 5d zur Entnahme aus dem Gehäuse 2 frei. Hierfür wird das Drückerteil 7d außer Zusammenwirkung mit der Aussparung 10d am Notschlüssel 5d bewegt. Vorliegend besitzt der Notschlüssel 5d zwei Aussparungen 10d, 11d zur Zusammenwirkung mit dem Drückerteil 7d, so dass der Notschlüssel 5d in zwei Rastpositionen im Gehäuse 2 fixierbar ist.

Weiter dient wenigstens ein Teil des Drückers 6d zur Fixierung des im Gehäuse 2 befindlichen Notschlüssels 5d am und/oder im Gehäuse 2, derart dass der Notschlüssel 5d weitgehend klapperfrei am und/oder im Gehäuse 2 eingesteckt ist. Hierfür weist der Drücker 6d das im Gehäuse 2 befindliches Druckteil 7d auf, wie in Fig. 2d zu sehen ist. Dadurch wirkt der Drücker 6d über das Druckteil 7d mittels einer elastischen Kraft, die von der nicht weiter gezeigten Feder am Drücker 6d erzeugt wird, auf den im Gehäuse 2 befindlichen Notschlüssel 5d ein. Schließlich gibt dann der Drücker 6d in einer zweiten gedrückten Stellung das abnehmbare Gehäuseteil 4" frei.

Wie man weiter anhand der Fig. 3d sieht, ist im Gehäuse 2, und zwar in dem einen Gehäuseteil 4', also im Gehäuseoberteil 4', ein Federelement 8d angeordnet. Das Federelement 8d ist in der Art einer federnden Lasche ausgestaltet und dient zur zusätzlichen, weitgehend klapperfreien Fixierung des Notschlüssels 5d am und/oder im Gehäuse 2, wenn sich der Notschlüssel 5d im Gehäuse 2 befindet.

Entsprechend der Fig. 2d befindet sich die Aussparung 10d, 11d an der einen Seitenfläche des Schlüsselbarts 9d. Dadurch wirkt die vom Drücker 6d ausgeübte elastische Kraft über das Drückerteil 7d auf die Seitenfläche des Schlüsselbarts 9d zur Fixierung des Notschlüssels 5d im Gehäuse 2 ein. Mittels des Federelements 8d wird eine elastische Kraft auf die eine Breitfläche des Schlüsselbarts 9d zur Fixierung des Notschlüssels 5d im Gehäuse 2 ausgeübt. Durch diese Fixierkräfte wird somit der im Gehäuse 2 befindliche Notschlüssel 5d in sämtlichen Richtungen festgehalten, womit ein zum Klappern führendes Spiel des Notschlüssels 5d im Gehäuse 2 wirksam verhindert ist.

Die Erfindung ist nicht auf das beschriebene und dargestellte Ausführungsbeispiel beschränkt. Sie umfasst vielmehr auch alle fachmännischen Weiterbildungen im Rahmen der durch die Patentansprüche definierten Erfindung. So kann ein erfindungsgemäßes Gehäuse 2 nicht nur für elektronische Kraftfahrzeug-Schlüssel eingesetzt werden sondern auch an Fernbedienungen für Fernseh- und/oder Audiogeräte, an Mobiltelefonen o. dgl. oder an sonstigen Bedienelementen Verwendung finden.

### Bezugszeichen-Liste:

- 1:: (elektronischer) Schlüssel
- 2:: Gehäuse (des Schlüssels)
- 3:: Bedienelement (am Schlüssel)
- 4':: Gehäuseteil / Gehäuseoberteil
- 4":: Gehäuseteil / Gehäuseunterteil
- 5:: Oberfläche (von Gehäuseteil)
- 6:: Betätigungsfläche
- 7:: Hand
- 8:: Element / Finger
- 9:: Sensor
- 10:: Display / Touchfeld
- 11:: Kondensator
- 12:: Leiterplatte
- 13:: Widerstandselement
- 14:: Sender / Leuchtdiode
- 15:: Empfänger / Fotodiode
- 16:: optische Strahlung
- 17:: Steuereinrichtung

- 5a:: Einhängenase
- 6a:: Fixierrippe
- 7a:: lichtdurchlässiges Element / Lichtleiter
- 8a:: Oberfläche (von Gehäuseteil)

- 5b:: Notschlüssel
- 6b:: Drücker
- 7b:: Rastelement
- 8b:: Schräge (an Rastelement)
- 9b, 10b:: Aussparung (an Notschlüssel)
- 11b:: Rasthaken
- 12:b: Anschlag
- 13b:: Schlüsselbart (von Notschlüssel)
- 14b:: Schräge (an Rasthaken)
- 15b:: Kappe

- 5c:: Notschlüssel
- 6c:: Drücker
- 7c:: Anschlag (Hebel)
- 8c:: Anschlag (Lasche)
- 9c:: Schlüsselbart
- 10c:: Haken

- 5d:: Notschlüssel
- 6d:: Drücker
- 7d:: Drückerteil / Druckteil
- 8d:: Federelement
- 9d:: Schlüsselbart (von Notschlüssel)
- 10d, 11d:: Aussparung (an Notschlüssel)

## Patentansprüche

1. Elektronischer Schlüssel für ein Schließsystem eines Kraftfahrzeugs mit einem Gehäuse (2), umfassend wenigstens ein Gehäuseteil (4', 4"), wobei an dem einen Gehäuseteil (4') wenigstens ein Touchfeld (10) als Bedienelement (3) mit einer Betätigungsfläche (6) zur manuellen Einwirkung mittels eines Elements (8) befindlich ist, wobei die Betätigung des Bedienelements (3) zum Schalten und/oder Auslösen einer zugeordneten Funktion dient, wobei das eine Gehäuseteil (4') eine geschlossene Oberfläche (5) aufweist, und wobei die Betätigungsfläche (6) mit einem stetigen und/oder unterbrechungslosen und/oder fugenlosen Übergang zwischen der Betätigungsfläche (6) und der Oberfläche (5) des Gehäuseteils (4') in der Oberfläche (5) des Gehäuseteils (4') befindlich ist, **dadurch gekennzeichnet, dass** das Bedienelement (3) lediglich nach Freigabe einer zur Vermeidung von Fehlbetätigungen vorgesehenen Tastensperre vom Benutzer betätigbar ist, wobei die Tastensperre eine Wisch- und/oder Gestenfunktion für das Touchfeld (10) umfasst.

2. Elektronischer Schlüssel nach Anspruch 1 **dadurch gekennzeichnet, dass** die Wisch- und/oder Gestenfunktion zur Freigabe bzw. zum Lösen der Tastensperre vorgesehen ist und erst danach das Bedienelement (1) vom Benutzer betätigbar ist.

3. Elektronischer Schlüssel nach einem der vorgenannten Ansprüche **dadurch gekennzeichnet, dass** eine haptische Rückmeldung der Betätigung des Bedienelements (3) durch das Element (8) mittels einer Vibration der Betätigungsfläche (6) vorgesehen ist.

4. Elektronischer Schlüssel nach einem der vorgenannten Ansprüche **dadurch gekennzeichnet, dass** zusätzlich zur Zugangsberechtigung zum Kraftfahrzeug durch Austausch entsprechender codierter elektromagnetischer Signale zwischen dem Schlüssel 1 und dem Kraftfahrzeug die Authentifikation des Schlüssels 1 zur Fahrberechtigung für das Kraftfahrzeug erfolgt.

5. Elektronischer Schlüssel nach einem der vorgenannten Ansprüche **dadurch gekennzeichnet, dass** in einem Gehäuseteil (4',4") ein lichtdurchlässiges Element (7a) befindlich ist, das als eine Funktionsanzeige und/oder als eine Funktionsbeleuchtung für den Schlüssel dient und aus einem Lichtleiter besteht, der in das Gehäuse (4',4 ") integriert ist.

6. Elektronischer Schlüssel nach einem der vorgenannten Ansprüche **dadurch gekennzeichnet, dass** zur Integration des Lichtleiters (7a) das Gehäuseteil(4") im 2K (Zwei-Komponenten)-Spritzgußverfahren hergestellt ist.

7. Elektronischer Schlüssel nach einem der vorgenannten Ansprüche **dadurch gekennzeichnet, dass** der Lichtleiter (7a) aus einem transluzenten Kunststoff sowie das restliche Gehäuseteil (4") aus einem nicht transluzenten Kunststoff besteht.

8. Elektronischer Schlüssel nach einem der vorgenannten Ansprüche **dadurch gekennzeichnet, dass** ein Sensor (9) mit der Betätigungsfläche (6) derart zusammenwirkt, dass der Sensor (9) bei Annäherung des Elements (8) an die Betätigungsfläche (6) und/oder bei Berührung der Betätigungsfläche (6) mittels des Elements (8) und/oder bei Druckeinwirkung mittels des Elements (8) auf die Betätigungsfläche (6) ein Signal erzeugt.

9. Elektronischer Schlüssel nach einem der vorgenannten Ansprüche **dadurch gekennzeichnet, dass** das Signal in der Art eines Schaltsignals zum Schalten und/oder Auslösen der zugeordneten Funktion dient.

10. Elektronischer Schlüssel nach einem der vorgenannten Ansprüche **dadurch gekennzeichnet, dass** die Oberfläche (5) des Gehäuseteils (4') eine geschlossene Folie und/oder ein transparentes Schutzfenster aufweist.

11. Elektronischer Schlüssel nach einem der vorgenannten Ansprüche **dadurch gekennzeichnet, dass** das Gehäuseteil (4') ein unter der Folie und/oder dem Schutzfenster liegendes Display (10) aufweist.

12. Elektronischer Schlüssel nach einem der vorgenannten Ansprüche **dadurch gekennzeichnet, dass** das Touchfeld (10) ein Touchpad und/oder einen Touchscreen aufweist.

13. Elektronischer Schlüssel nach einem der vorgenannten Ansprüche **dadurch gekennzeichnet, dass** der Sensor (9) für das Touchfeld (10) kapazitiv oder resistiv oder optisch arbeitet.

14. Elektronischer Schlüssel nach einem der vorgenannten Ansprüche **dadurch gekennzeichnet, dass** der optische Sensor (9) mittels Infrarot(IR)-Strahlung arbeitet.

15. Elektronischer Schlüssel nach einem der vorgenannten Ansprüche **dadurch gekennzeichnet, dass** eine visuelle Rückmeldung der Betätigung des Bedienelements (3) durch das Element (8) vorgesehen ist.

16. Elektronischer Schlüssel nach einem der vorgenannten Ansprüche **dadurch gekennzeichnet, dass** die Rückmeldung mittels einer Displayanzeige oder mittels eines Anzeige-Leuchtmittels erfolgt.

17. Elektronischer Schlüssel nach einem der vorgenannten Ansprüche **dadurch gekennzeichnet, dass** es sich bei dem Anzeige-Leuchtmittel um eine Anzeige-LED handelt.

18. Elektronischer Schlüssel nach einem der vorgenannten Ansprüche **dadurch gekennzeichnet, dass** es sich bei dem Element (8) um den Finger einer menschlichen Hand (7) handelt.

19. Elektronischer Schlüssel nach einem der vorgenannten Ansprüche **dadurch gekennzeichnet, dass** das Gehäuse (2) ein Gehäuseunterteil (4") und/oder ein Gehäuseoberteil (4') umfasst.
